# EUROPEAN PATENT APPLICATION

(11) **EP 4 246 595 A1**
(43) Date of publication of application: **20.09.2023**
(21) Application number: 21890939.8
(22) Date of filing: 22.10.2021
(51) Int. Cl.: H01L 29/78

(54) **TRENCH POWER DEVICE AND MANUFACTURING METHOD THEREFOR**

(30) Priority: 12.11.2020 CN 202011264302
(71) Applicant: Chongqing Alpha and Omega Semiconductor Limited, Chongqing 400700 (CN)
(72) Inventor: YANG, Li, Chongqing 400700 (CN); SHI, Liang, Chongqing 400700 (CN)
(74) Representative: Meyer-Dulheuer MD Legal Patentanwälte PartG mbB
(86) International application number: PCT/CN2021/125685
(87) International publication number: WO 2022/100412

(57) **Abstract**

A trench type power device and a manufacturing method of the trench type power device are provided, which relate to a technical field of manufacturing power semiconductor devices. The manufacturing method includes steps of preparing a cellular structure, preparing contact holes and tungsten bolts, performing etching to form a circuit, and depositing a passivation layer and etching the passivation layer, which overcomes limitation on relative positions of the gate trench and source trench from technology capability of photoetching machines, so as to further improve the integration level. Moreover, simultaneously manufacturing the gate trench and the source trench overcomes difficulties of the photoetching technology and reduces cellular density and on-resistance, so as to improve efficiency of the trench type power device. And, there is no other mask additionally added.

## Description

### TECHNICAL FIELD

The present disclosure relates to a technical field of manufacturing power semiconductor devices, and in particular to a trench type power device and a manufacturing method of the trench type power device.

### BACKGROUND

With the attention of the society to environmental protection, power devices have increasingly significant status in electronic power applications due to characteristics of energy saving and electricity saving. In particular, trench type power devices have advantages of low on-resistance, high integration level, etc., and are favored by market applications.

Chinese patent having publication number of CN102956481B provides a manufacturing method of a trench type power semiconductor device having a source trench, including forming at least two gate trenches in a substrate, sequentially forming a first dielectric layer and a first polysilicon structure in each of the at least two gate trenches, forming at least one source trench between adjacent two of the at least two gate trenches, sequentially forming a second dielectric layer and a second polysilicon structure in the at least one source trench and locating the second polysilicon structure at a lower portion of the source trench, removing a part of the second dielectric layer for exposing a source region and a body region, and filing a conductive structure in the at least one source trench for electrically connecting the second polysilicon structure, the body region, and the source region. The present disclosure provides a manufacturing method of a trench type power device having a source trench, which effectively reduces a distance between adjacent two gate trenches, so as to achieve a purpose of reducing an on-resistance.

In the Chinese patent having the publication number of CN102956481B, the at least two gate trenches are first manufactured, and after a cellular structure is completely formed, manufacturing of the at least one source trench is performed. Such a method has a relatively high requirements in photoetching alignment and limits reduction of cellular density. Moreover, by a structure characteristic of the trench type semiconductor power device, the trench type semiconductor power device has a relatively high requirement on relative positions of the at least two gate trenches and the at least one source trench, so that further improvement of an integration level of the trench type semiconductor power device is limited by technology of photoetching machines.

### SUMMARY

In order to overcome defects in the prior art, the present disclosure aims to provide a trench type power device and a manufacturing method of the trench type power device.

The present disclosure is achieved by following technical solutions of a manufacturing method of a trench type power device, including:
step A, preparing a cellular structure;
step B, preparing contact holes and tungsten bolts;
step C, performing etching to form a circuit; and
step D, depositing a passivation layer and etching the passivation layer.

Furthermore, the step A specifically includes:
step S1, performing chemical vapor deposition on an upper surface of a silicon substrate with one or more epitaxial layers, where each of the one or more epitaxial layers is doped with trivalent elements and pentavalent elements;
step S2, depositing a mask on an upper surface of each of the one or more epitaxial layers, where a component of the mask is a photoresist or a multi-layer combination structure composed of a photoresist and an insulator mask, for example, a multi-layer combination of silicon dioxide-silicon nitride-silicon dioxide, where the silicon dioxide and the silicon nitride are prepared through the chemical vapor deposition and the photoresist is spin-coated through a photoetching technology;
step S3, defining a pattern of a gate trench and a pattern of a source trench on the mask, where the gate trench includes a cellular gate trench and a gate interconnection trench, a pattern of the cellular gate trench, the pattern of the source trench, and a pattern of the gate interconnection trench are sequentially arranged, a critical dimension of the gate interconnection trench is greater than a critical dimension of the cellular gate trench, and the critical dimension of the cellular gate trench is greater than a critical dimension of the source trench; since the method simultaneously manufactures the gate trench and the source trench, a limitation to the photoetching technology on an integration level is broken through, and the circuit is exposed to the photoresist using the mask; if a multi-layer insulator structure is employed at a lower layer of the photoresist, then dry etching is required to form a pattern of the circuit onto the multi-layer insulator structure.
step S4, forming the pattern of the circuit on the mask, and then forming the pattern of the circuit on each of the one or more epitaxial layers through the dry etching; due to characteristics of the dry etching, the gate trench having a larger critical dimension is etched deeper, the source trench is etched shallow, so that a depth of the gate interconnection trench, a depth of the cellular gate trench, and a depth of the source trench are obtained, where the depth of the gate interconnection trench, the depth is greater than the depth of the cellular gate trench, and the depth of the cellular gate trench is greater than the depth of the source trench;
step S5, performing rounding and plasma damage repair on the cellular gate trench, the source trench, and the gate interconnection trench through a thermal oxidation method, growing an oxide layer on each of side walls of the cellular gate trench, the source trench, and the gate interconnection trench, and processing the oxide layer through wet etching to service as a cushion layer of a silicon nitride thin film;
step S6, growing the silicon nitride thin film through low-pressure chemical vapor deposition, since the gate trench is etched deeper and the source trench is etched shallow, the silicon nitride thin film grows on a bottom surface of the gate trench and fills the source trench;
step S7, etching the silicon nitride thin film through hot phosphoric acid, where the silicon nitride thin film is still retained in the source trench until the silicon nitride thin film in the gate trench is completely etched;
step S8, removing a natural oxide layer in the gate trench through the wet etching, and growing a gate oxide layer through the thermal oxidation method;
step S9, forming polysilicon through low-pressure chemical vapor deposition for filling the gate trench with the polysilicon to form a gate, doping the pentavalent elements in a deposition process of the polysilicon or doping the trivalent elements through ion implantation after the gate is formed;
step S10, removing a part of the polysilicon higher than the one or more epitaxial layers through chemical mechanical polishing or the dry etching;
step S11, doping a first impurity into the upper surface of each of the one or more epitaxial layers through the ion implantation to obtain a body region, activating the first impurity in the body region through a thermal process, where the first impurity includes the trivalent elements or the pentavalent elements; and
step S12, doping a second impurity into an upper surface of the body region through the ion implantation to obtain a source region, where the second impurity implanted by the ion implantation is the pentavalent elements or the trivalent elements, so as to finally obtain the cellular structure.

Furthermore, in the step S1, the step S9, the step S11, and the step S12, the trivalent elements include boron element, and the pentavalent elements include arsenic element and phosphorus element.

Furthermore, a polarity of the first impurity doped through the ion implantation in the step S11 is opposite to a polarity of the trivalent elements and the pentavalent elements doped in each of the one or more epitaxial layers in the step S1, and a polarity of the second impurity doped by the ion implantation in the step 12 is same as the polarity of the trivalent elements and the pentavalent elements doped in each of the one or more epitaxial layers in the step S1, and the polarity of the trivalent elements is opposite to the polarity of the pentavalent elements.

Furthermore, a thickness of the oxide layer in the step S5 is 10-100 nm, a thickness of the oxide layer after being processed by the wet etching is 20 nm; a thickness of the silicon nitride thin film in the step S6 is 500-1000 nm, a thickness of the gate oxide layer in the step S8 is 10-100 nm, and a thickness of the polysilicon in the step S9 is 500-1000 nm.

Furthermore, the step B specifically includes:
step S13, forming a silicon dioxide dielectric layer through chemical vapor deposition, where the silicon dioxide dielectric layer is capable of being doped with boron-phosphorus impurities for improving fluidity and foreign impurity adsorbability of the silicon dioxide dielectric layer;
step S14, configuring the photoresist to define a pattern of a source region trench contact hole and a pattern of a gate interconnection region contact hole through the photoetching technology, where the pattern of the source region trench contact hole is located above the source trench, and the pattern of the gate interconnection region contact hole is located above the gate interconnection trench; since the source region trench is formed previously, at this time, critical dimensions of the pattern of the source region trench contact hole and the pattern of the gate interconnection region contact hole are relatively large, which has good tolerance of the photoetching technology;
step S 15, etching the silicon dioxide dielectric layer through the dry etching to obtain the source region trench contact hole and the gate interconnection trench contact hole;
step S 16, etching silicon nitride in a source region trench through hot phosphoric acid;
step S 17, doping a third impurity having high concentration to a bottom of the source region trench, forming an ohmic contact of the source region trench contact hole, and activating the third impurity trough rapid thermal annealing; depositing metal and nitride as a protective layer through a physical vapor deposition technology, forming silicide through rapid thermal degradation, where the metal includes one or more of titanium, cobalt, and tantalum; and
step S18, depositing metal tungsten through a tungsten bolt technology, removing a part of the metal tungsten other than each of the contact holes through the dry etching, and forming each of the tungsten bolts in each of the contact holes.

Furthermore, the polarity of the second impurity doped through the ion implantation in the step S12 is same as a polarity of the third impurity doped through the ion implantation in the step S 17.

Furthermore, the step C specifically includes:
step S19, respectively depositing aluminum-copper compound above the tungsten bolts though the physical vapor deposition technology, then performing the etching through a photoetching technology and dry etching to form the circuit.

Furthermore, the step D specifically includes:
step S20, depositing the passivation layer and etching the passivation layer through a photoetching technology, where the passivation layer includes silicon nitride or silicon dioxide.

The present disclosure further provides a trench type power device, and the trench type device is obtained through the manufacturing method of the trench type power device.

In summary, compared with the prior art, the present disclosure has following beneficial effects:
(1) the present disclosure overcomes limitation on relative positions of the gate trench and source trench from technology capability of photoetching machines, so as to further improve the integration level;
(2) the present disclosure simultaneously manufactures the gate trench and the source trench, so as to overcome difficulties of the photoetching technology;
(3) since no other masks are additionally added, a cost of the trench type power device and the manufacturing method thereof is controllable; and
(4) the present disclosure further reduces cellular density and on-resistance, so as to improve efficiency of the trench type power device.

### BRIEF DESCRIPTION OF DRAWINGS

Other features, objects, and advantages of the present disclosure would become more apparent by reading following detailed description of non-limiting embodiments with reference to following drawings.
FIG. 1 is a schematic diagram of an epitaxial layer after depositing through a technological process in step S 1 of a manufacturing method of a trench type power device according to embodiments 1-3 of the present disclosure.
FIG. 2 is a schematic diagram of a mask after depositing through a technological process in step S2 of the manufacturing method of the trench type power device according to embodiments 1-3 of the present disclosure.
FIG. 3 is a schematic diagram of trenches in a technological process in step S3 of the manufacturing method of the trench type power device according to embodiments 1-3 of the present disclosure.
FIG. 4 is a schematic diagram of trenches after etching through a technological process in step S4 of the manufacturing method of the trench type power device according to embodiments 1-3 of the present disclosure.
FIG. 5 is a schematic diagram of an oxide layer in a technological process in step S5 of the manufacturing method of the trench type power device according to embodiments 1-3 of the present disclosure.
FIG. 6 is a schematic diagram of a silicon nitride thin film in a technological process in step S6 of the manufacturing method of the trench type power device according to embodiments 1-3 of the present disclosure.
FIG. 7 is a structural schematic diagram of a gate trench after etching through a technological process in step S7 of the manufacturing method of the trench type power device according to embodiments 1-3 of the present disclosure.
FIG. 8 is a schematic diagram of a gate oxide layer in a technological process in step S8 of the manufacturing method of the trench type power device according to embodiments 1-3 of the present disclosure.
FIG. 9 is a schematic diagram of polysilicon in a technological process in step S9 of the manufacturing method of the trench type power device according to embodiments 1-3 of the present disclosure.
FIG. 10 is a structural schematic diagram of the trenches after polishing or etching through a technological process in step S10 of the manufacturing method of the trench type power device according to embodiments 1-3 of the present disclosure.
FIG. 11 is a schematic diagram of a body region after performing ion implantation in step S11 of the manufacturing method of the trench type power device according to embodiments 1-3 of the present disclosure.
FIG. 12 is a schematic diagram of a source region a technological process in step S12 of the manufacturing method of the trench type power device according to embodiments 1-3 of the present disclosure.
FIG. 13 is a schematic diagram of a silicon dioxide dielectric layer in a technological process in step S13 of the manufacturing method of the trench type power device according to embodiments 1-3 of the present disclosure.
FIG. 14 is a schematic diagram of contact holes after performing a photoetching technology in step S14 of the manufacturing method of the trench type power device according to embodiments 1-3 of the present disclosure.
FIG. 15 is a schematic diagram of the contact holes in a technological process in step S15 of the manufacturing method of the trench type power device according to embodiments 1-3 of the present disclosure.
FIG. 16 is a schematic diagram of a source region trench after etching through a technological process in step S16 of the manufacturing method of the trench type power device according to embodiments 1-3 of the present disclosure.
FIG. 17 is a schematic diagram of an ohmic contact in a technological process in step S17 of the manufacturing method of the trench type power device according to embodiments 1-3 of the present disclosure.
FIG. 18 is a schematic diagram of tungsten bolts in a technological process in step S18 of the manufacturing method of the trench type power device according to embodiments 1-3 of the present disclosure.
FIG. 19 is a schematic diagram of a circuit in a technological process in step S19 of the manufacturing method of the trench type power device according to embodiments 1-3 of the present disclosure.
FIG. 20 is a schematic diagram of a passivation layer after depositing through a technological process in step S20 of the manufacturing method of the trench type power device according to embodiments 1-3 of the present disclosure.

Numerals in the drawings: 1. silicon substrate; 2. epitaxial layer; 3. mask; 4. cellular gate trench; 5. source trench; 6. gate interconnection trench; 7. oxide layer; 8. silicon nitride thin film; 9. gate oxide layer; 10. polysilicon; 11. body region; 12. source region; 13. silicon dioxide dielectric layer; 14. source region trench contact hole; 15. gate interconnection region contact hole; 16. ohmic contact; 17. tungsten bolt; 18. aluminum-copper compound; 19. passivation layer.

### DETAILED DESCRIPTION

Following embodiments would help those who skilled in the art to further understand the present disclosure, but do not limit the present disclosure in any form. Those who skilled in the art may make several changes and improvements without departing from a concept of the present disclosure, all of which fall within the protection scope of the present disclosure. Endpoints and any values of ranges disclosed herein are not limited to this precise range or value, which should be understood to include values close to those ranges or values. For a numerical range, one or more new numerical ranges may be obtained by combining endpoint values of various ranges, combing the endpoint values of various ranges and separate point values, and combing separate point values, which should be considered as specifically disclosed herein, and the present disclosure is described in detail below with reference to specific embodiments.

### Embodiment 1

The present disclosure provides a manufacturing method of a trench type power device, including following steps.

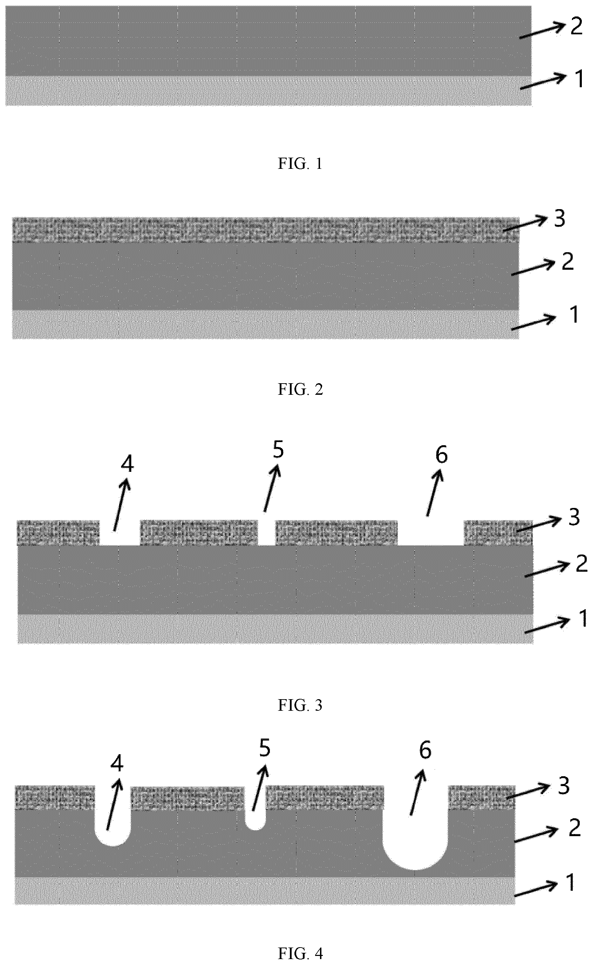

In step S1, as shown in FIG. 1, epitaxial layers 2 are grown on a silicon substrate 1, and the epitixial layers 2 are grown through chemical vapor deposition. The epitaxial layers 2 are capable of being doped with trivalent elements and pentavalent elements according to different polarities of the trench type power device. In the embodiment, the epitaxial layers 2 are doped with the trivalent elements. The epitaxial layers 2 may have micron-level changes in depths or in a multi-layer structure according to different operating voltages.

In step S2, as shown in FIG. 2, a mask 3 for forming trenches is deposited. The mask 3 is a photoresist or a multi-layer combination structure composed of a photoresist and an insulator mask, for example, a multi-layer combination of silicon dioxide-silicon nitride-silicon dioxide, where the silicon dioxide and the silicon nitride are prepared through the chemical vapor deposition and the photoresist is spin-coated through a photoetching technology. The mask 3 in the embodiment is the photoresist.

In step S3, as shown in FIG. 3, a gate trench and a source trench 5 are defined. Since the method simultaneously manufactures the gate trench and the source trench 5, a limitation to the photoetching technology on an integration level is broken through, a critical dimension of the source trench 5 is narrower than a critical dimension of the gate trench, where the gate trench includes a cellular gate trench 4 and a gate interconnection trench 6. The circuit is exposed to the photoresist using the mask. If a multi-layer insulator structure is employed at a lower layer of the photoresist, then dry etching is required to form a pattern of the circuit onto the multi-layer insulator structure.

In step S4, as shown in FIG. 4, after the pattern of the circuit is formed on the mask, the pattern of the circuit is formed on each of the epitaxial layers 2. Due to characteristics of the dry etching, the gate trench including the cellular gate trench 4 and the gate interconnection trench 6 and having a larger critical dimension is etched deeper, the source trench 5 is etched shallow.

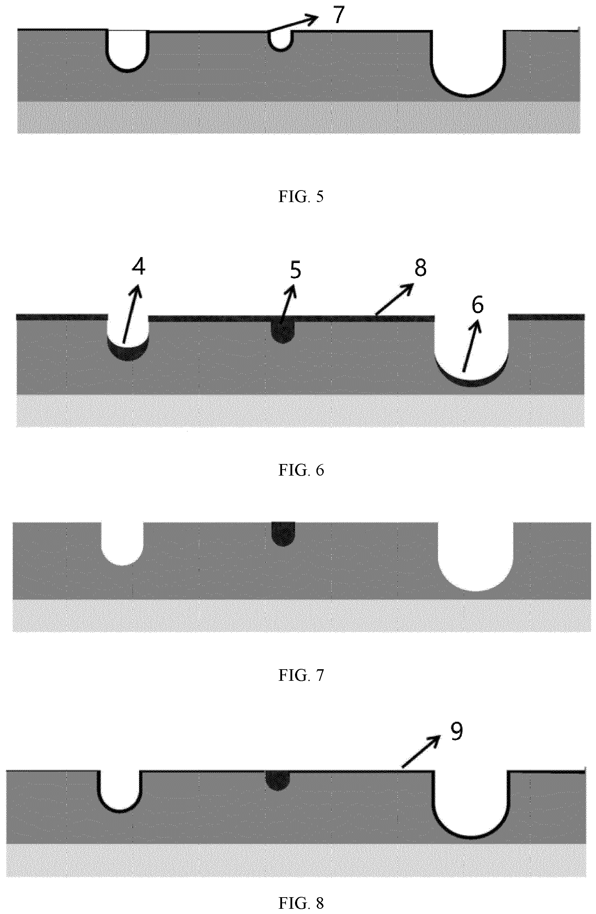

In step S5, as shown in FIG. 5, rounding and plasma damage repair are performed on the cellular gate trench 4, the source trench 5, and the gate interconnection trench 6 through a thermal oxidation method. A thickness of the oxide layer 7 in grown to be 20 nm to serve as a cushion layer of a silicon nitride thin film.

In step S6, as shown in FIG. 6, the silicon nitride thin film is grown to be 500 nm through low-pressure chemical vapor deposition. Since the gate trench is etched deeper, the silicon nitride thin film grows on bottom surfaces of the cellular gate trench 4 and the gate interconnection trench 6, and since the source trench 5 is etched shallow, the silicon nitride thin film may fully fill the source trench and exceed a silicon surface.

In step S7, as shown in FIG. 7, the silicon nitride thin film is etched through hot phosphoric acid, and a time for etching needs to be precisely controlled. The silicon nitride thin film is still retained in the source trench 5 until the silicon nitride thin film in the gate trench is completely etched.

In step S8, as shown in FIG. 8, a gate oxide layer 9 is formed. First, a natural oxide layer in the gate trench is removed through the wet etching, then the gate oxide layer 9 which is 10 nm is grown through the thermal oxidation method according to different applications.

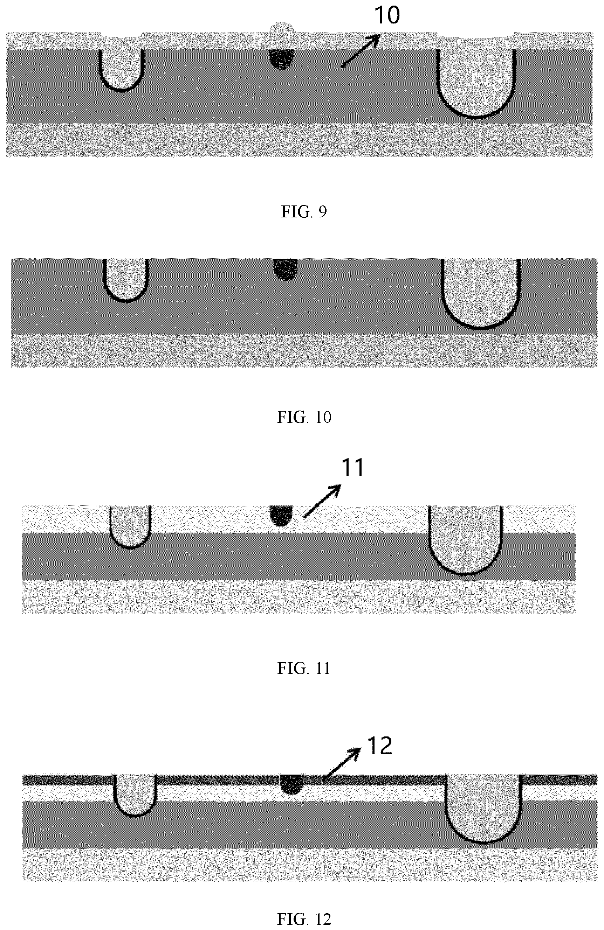

In step S9, as shown in FIG. 9, a gate is formed using low-pressure chemical vapor deposition, and polysilicon 10 having a thickness of 500 nm is deposited. According to different polarities of the trench type power device, the pentavalent elements are doped in a deposition process, or, the trivalent elements are doped through ion implantation after the gate is formed. At this time the gate trench is filled with the polysilicon 10, and due to a blocking of the silicon nitride thin film, the polysilicon 10 does not form in the source trench 5.

In step S10, as shown in FIG. 10, removing a part of the polysilicon higher than the one or more epitaxial layers through chemical mechanical polishing or the dry etching.

In step S11, as shown in FIG. 11, obtaining a body region 11 through the ion implantation, and activating an impurity in the body region 11 through a thermal process. According to different polarities of the trench type power device, the impurity implanted by the ion implantation may be the trivalent elements or the pentavalent elements including the arsenic element and the phosphorus element. In the embodiment, the impurity implanted by the ion implantation is the trivalent elements.

In step S12, as shown in FIG. 12, obtaining a source region 12 through the ion implantation. According to different polarities of the trench type power device, the impurity implanted by the ion implantation may be the pentavalent elements including the arsenic element and the phosphorus element or the trivalent elements. In the embodiment, the impurity implanted by the ion implantation is the pentavalent elements.

At this step, a basic cellular structure is formed. Following steps are mainly to isolate the trench type power device from being interconnected with metals.

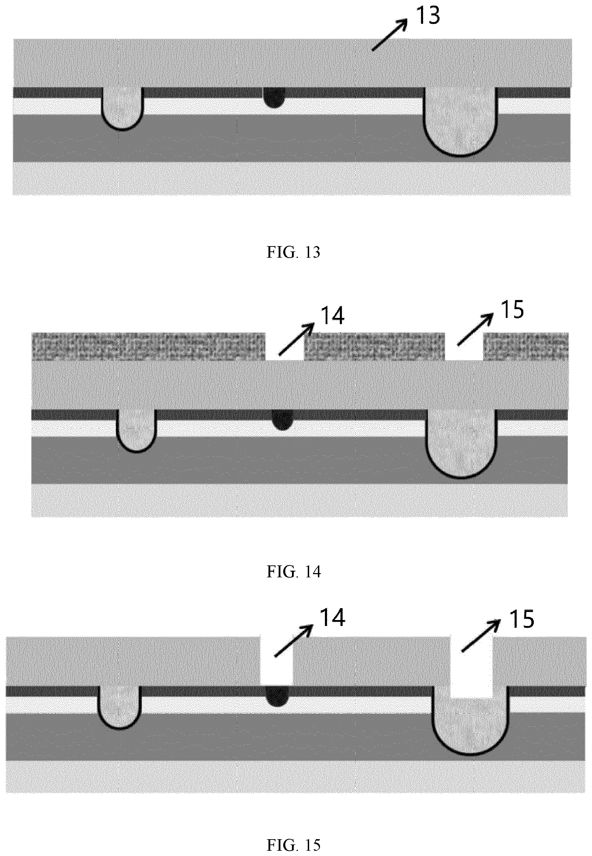

In step S13, as shown in FIG. 13, forming a silicon dioxide dielectric layer 13 through chemical vapor deposition, where the silicon dioxide dielectric layer 13 is capable of being doped with boron-phosphorus impurities for improving fluidity and foreign impurity adsorbability of the silicon dioxide dielectric layer 13.

In step S14, as shown in FIG. 14, configuring the photoresist to define a pattern of a source region trench contact hole 14 and a pattern of a gate interconnection region contact hole 15 through the photoetching technology. Since the source region trench is formed previously, at this time, critical dimensions of the pattern of the source region trench contact hole and the pattern of the gate interconnection region contact hole are relatively large, which has good tolerance of the photoetching technology.

In step S15, as shown in FIG. 15, etching the silicon dioxide dielectric layer 13 through the dry etching to obtain the source region trench contact hole 14 and the gate interconnection trench contact hole 15.

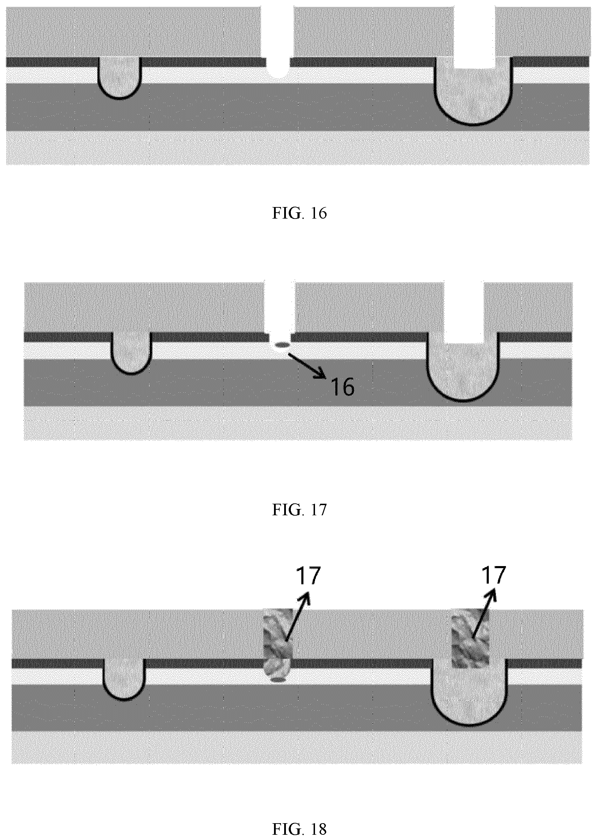

In the step S16, as shown in FIG. 16, etching silicon nitride in a source region trench through hot phosphoric acid.

In the step S17, as shown in FIG. 17, doping an impurity having high concentration to a bottom of the source region trench, forming an ohmic contact 16 of the source region trench contact hole, and activating the impurity trough rapid thermal annealing; depositing metal and nitride as a protective layer through a physical vapor deposition technology, forming silicide through rapid thermal degradation, where the metal includes one or more of titanium, cobalt, and tantalum.

In the step S18, as shown in FIG. 18, depositing metal tungsten through a tungsten bolt technology, removing a part of the metal tungsten other than each of the contact holes through the dry etching, to obtain tungsten bolts 17.

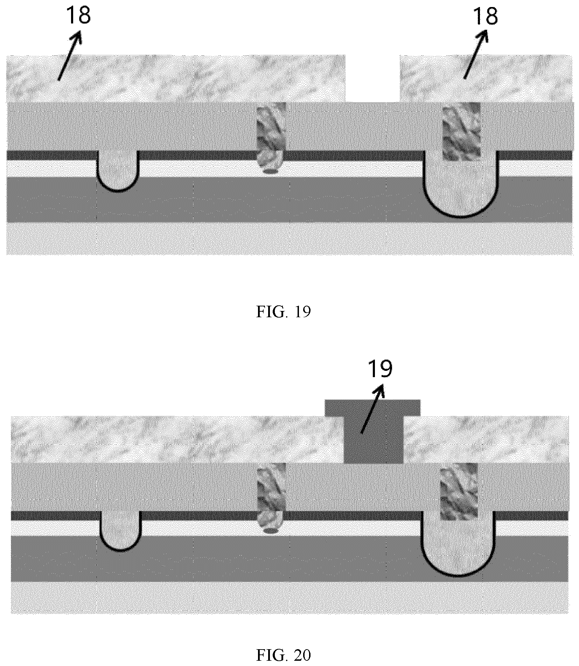

In the step S19, as shown in FIG. 19, respectively depositing aluminum-copper compound 18 though the physical vapor deposition technology, forming the circuit through the photoetching technology and the dry etching.

In the step S20, as shown in FIG. 20, depositing a passivation layer 19 and etching the passivation layer 19 through the photoetching technology, where the passivation layer 19 includes silicon nitride or silicon dioxide.

Finally performing an alloying technology, at this point, the manufacturing method of the trench type power device is completed.

### Embodiment 2

The present disclosure provides a manufacturing method of a trench type power device, including following steps:
In step S1, as shown in FIG. 1, epitaxial layers 2 are grown on a silicon substrate 1, and the epitixial layers 2 are grown through chemical vapor deposition. The epitaxial layers 2 are capable of being doped with trivalent elements and pentavalent elements according to different polarities of the trench type power device. In the embodiment, the epitaxial layers 2 are doped with the trivalent elements. The epitaxial layers 2 may have micron-level changes in depths or in a multi-layer structure according to different operating voltages.
In step S2, as shown in FIG. 2, a mask 3 for forming trenches is deposited. The mask 3 is a photoresist or a multi-layer combination structure composed of a photoresist and an insulator mask, for example, a multi-layer combination of silicon dioxide-silicon nitride-silicon dioxide, where the silicon dioxide and the silicon nitride are prepared through the chemical vapor deposition and the photoresist is spin-coated through a photoetching technology. The mask 3 in the embodiment is the multi-layer combination structure composed of the photoresist and the silicon dioxide-silicon nitride-silicon dioxide.
In step S3, as shown in FIG. 3, a gate trench and a source trench 5 are defined. Since the method simultaneously manufactures the gate trench and the source trench 5, a limitation to the photoetching technology on an integration level is broken through, a critical dimension of the source trench 5 is narrower than a critical dimension of the gate trench, where the gate trench includes a cellular gate trench 4 and a gate interconnection trench 6. The circuit is exposed to the photoresist using the mask. If a multi-layer insulator structure is employed at a lower layer of the photoresist, then dry etching is required to form a pattern of the circuit onto the multi-layer insulator structure.
In step S4, as shown in FIG. 4, after the pattern of the circuit is formed on the mask, the pattern of the circuit is formed on each of the epitaxial layers 2. Due to characteristics of the dry etching, the gate trench including the cellular gate trench 4 and the gate interconnection trench 6 and having a larger critical dimension is etched deeper, the source trench 5 is etched shallow.
In step S5, as shown in FIG. 5, rounding and plasma damage repair are performed on the cellular gate trench 4, the source trench 5, and the gate interconnection trench 6 through a thermal oxidation method. A thickness of the oxide layer 7 in grown to be 50 nm, removing a part of the oxide layer 7 through the wet etching, and leaving over 20 nm of the oxide layer to serve as a cushion layer of a silicon nitride thin film.
In step S6, as shown in FIG. 6, the silicon nitride thin film is grown to be about 800 nm through low-pressure chemical vapor deposition. Since the gate trench is etched deeper, the silicon nitride thin film grows on bottom surfaces of the cellular gate trench 4 and the gate interconnection trench 6, and since the source trench 5 is etched shallow, the silicon nitride thin film may fully fill the source trench and exceed a silicon surface.
In step S7, as shown in FIG. 7, the silicon nitride thin film is etched through hot phosphoric acid, and a time for etching needs to be precisely controlled. The silicon nitride thin film is still retained in the source trench 5 until the silicon nitride thin film in the gate trench is completely etched.
In step S8, as shown in FIG. 8, a gate oxide layer 9 is formed. First, a natural oxide layer in the gate trench is removed through the wet etching, then the gate oxide layer 9 which is between 50 nm is grown through the thermal oxidation method according to different applications.
In step S9, as shown in FIG. 9, a gate is formed using low-pressure chemical vapor deposition, and polysilicon 10 having a thickness of 800 nm is deposited. According to different polarities of the trench type power device, the pentavalent elements are doped in a deposition process, or, the trivalent elements are doped through ion implantation after the gate is formed. At this time the gate trench is filled with the polysilicon 10, and due to a blocking of the silicon nitride thin film, the polysilicon 10 does not form in the source trench 5.
In step S10, as shown in FIG. 10, removing a part of the polysilicon higher than the one or more epitaxial layers through chemical mechanical polishing or the dry etching.
In step S11, as shown in FIG. 11, obtaining a body region 11 through the ion implantation, and activating an impurity in the body region 11 through a thermal process. According to different polarities of the trench type power device, the impurity implanted by the ion implantation may be the trivalent elements or the pentavalent elements including the arsenic element and the phosphorus element. In the embodiment, the impurity implanted by the ion implantation is the pentavalent elements.
In step S12, as shown in FIG. 12, obtaining a source region 12 through the ion implantation. According to different polarities of the trench type power device, the impurity implanted by the ion implantation may be the pentavalent elements including the arsenic element and the phosphorus element or the trivalent elements. In the embodiment, the impurity implanted by the ion implantation is the trivalent elements. At this step, a basic cellular structure is formed. Following steps are mainly to isolate the trench type power device from being interconnected with metals.
In step S13, as shown in FIG. 13, forming a silicon dioxide dielectric layer 13 through chemical vapor deposition, where the silicon dioxide dielectric layer 13 is capable of being doped with boron-phosphorus impurities for improving fluidity and foreign impurity adsorbability of the silicon nitride thin film.
In step S14, as shown in FIG. 14, configuring the photoresist to define a pattern of a source region trench contact hole 14 and a pattern of a gate interconnection region contact hole 15 through the photoetching technology. Since the source region trench is formed previously, at this time, critical dimensions of the pattern of the source region trench contact hole and the pattern of the gate interconnection region contact hole are relatively large, which has good tolerance of the photoetching technology.
In step S15, as shown in FIG. 15, etching the silicon dioxide dielectric layer 13 through the dry etching to obtain the source region trench contact hole 14 and the gate interconnection trench contact hole 15.
In the step S16, as shown in FIG. 16, etching silicon nitride in a source region trench through hot phosphoric acid.
In the step S 17, as shown in FIG. 17, doping an impurity having high concentration to a bottom of the source region trench, forming an ohmic contact 16 of the source region trench contact hole, and activating the impurity trough rapid thermal annealing; depositing metal and nitride as a protective layer through a physical vapor deposition technology, forming silicide through rapid thermal degradation, where the metal includes one or more of titanium, cobalt, and tantalum.
In the step S 18, as shown in FIG. 18, depositing metal tungsten through a tungsten bolt technology, removing a part of the metal tungsten other than each of the contact holes through the dry etching, to obtain tungsten bolts 17.
In the step S19, as shown in FIG. 19, respectively depositing aluminum-copper compound 18 though the physical vapor deposition technology, forming the circuit through the photoetching technology and the dry etching.
In the step S20, as shown in FIG. 20, depositing a passivation layer 19 and etching the passivation layer 19 through the photoetching technology, where the passivation layer 19 includes silicon nitride or silicon dioxide_{∘}

Finally performing an alloying technology, at this point, the manufacturing method of the trench type power device is completed.

### Embodiment 3

In step S1, as shown in FIG. 1, epitaxial layers 2 are grown on a silicon substrate 1, and the epitixial layers 2 are grown through chemical vapor deposition. The epitaxial layers 2 are capable of being doped with trivalent elements and pentavalent elements according to different polarities of the trench type power device. In the embodiment, the epitaxial layers 2 are doped with the trivalent elements. The epitaxial layers 2 may have micron-level changes in depths or in a multi-layer structure according to different operating voltages.

In step S2, as shown in FIG. 2, a mask 3 for forming trenches is deposited. The mask 3 is a photoresist or a multi-layer combination structure composed of a photoresist and an insulator mask, for example, a multi-layer combination of silicon dioxide-silicon nitride-silicon dioxide, where the silicon dioxide and the silicon nitride are prepared through the chemical vapor deposition and the photoresist is spin-coated through a photoetching technology. The mask 3 in the embodiment is the photoresist.

In step S3, as shown in FIG. 3, a gate trench and a source trench 5 are defined. Since the method simultaneously manufactures the gate trench and the source trench 5, a limitation to the photoetching technology on an integration level is broken through, a critical dimension of the source trench 5 is narrower than a critical dimension of the gate trench, where the gate trench includes a cellular gate trench 4 and a gate interconnection trench 6. The circuit is exposed to the photoresist using the mask. If a multi-layer insulator structure is employed at a lower layer of the photoresist, then dry etching is required to form a pattern of the circuit onto the multi-layer insulator structure.

In step S4, as shown in FIG. 4, after the pattern of the circuit is formed on the mask, the pattern of the circuit is formed on each of the epitaxial layers 2. Due to characteristics of the dry etching, the gate trench including the cellular gate trench 4 and the gate interconnection trench 6 and having a larger critical dimension is etched deeper, the source trench 5 is etched shallow.

In step S5, as shown in FIG. 5, rounding and plasma damage repair are performed on the cellular gate trench 4, the source trench 5, and the gate interconnection trench 6 through a thermal oxidation method. A thickness of the oxide layer 7 in grown to be 100 nm, removing a part of the oxide layer 7 through the wet etching, and leaving over 20 nm of the oxide layer to serve as a cushion layer of a silicon nitride thin film.

In step S6, as shown in FIG. 6, the silicon nitride thin film is grown to be 1000 nm through low-pressure chemical vapor deposition. Since the gate trench is etched deeper, the silicon nitride thin film grows on bottom surfaces of the cellular gate trench 4 and the gate interconnection trench 6, and since the source trench 5 is etched shallow, the silicon nitride thin film may fully fill the source trench and exceed a silicon surface.

In step S7, as shown in FIG. 7, the silicon nitride thin film is etched through hot phosphoric acid, and a time for etching needs to be precisely controlled. The silicon nitride thin film is still retained in the source trench 5 until the silicon nitride thin film in the gate trench is completely etched.

In step S8, as shown in FIG. 8, a gate oxide layer 9 is formed. First, a natural oxide layer in the gate trench is removed through the wet etching, then the gate oxide layer 9 which is between 100 nm is grown through the thermal oxidation method according to different applications.

In step S9, as shown in FIG. 9, a gate is formed using low-pressure chemical vapor deposition, and polysilicon 10 having a thickness of 1000 nm is deposited. According to different polarities of the trench type power device, the pentavalent elements are doped in a deposition process, or, the trivalent elements are doped through ion implantation after the gate is formed. At this time the gate trench is filled with the polysilicon 10, and due to a blocking of the silicon nitride thin film, the polysilicon 10 does not form in the source trench 5.

In step S10, as shown in FIG. 10, removing a part of the polysilicon higher than the one or more epitaxial layers through chemical mechanical polishing or the dry etching.

In step S11, as shown in FIG. 11, obtaining a body region 11 through the ion implantation, and activating an impurity in the body region 11 through a thermal process. According to different polarities of the trench type power device, the impurity implanted by the ion implantation may be the trivalent elements or the pentavalent elements including the arsenic element and the phosphorus element. In the embodiment, the impurity implanted by the ion implantation is the pentavalent elements.

In step S12, as shown in FIG. 12, obtaining a source region 12 through the ion implantation. According to different polarities of the trench type power device, the impurity implanted by the ion implantation may be the pentavalent elements including the arsenic element and the phosphorus element or the trivalent elements. In the embodiment, the impurity implanted by the ion implantation is the trivalent elements.

At this step, a basic cellular structure is formed. Following steps are mainly to isolate the trench type power device from being interconnected with metals.

In step S13, as shown in FIG. 13, forming a silicon dioxide dielectric layer 13 through chemical vapor deposition, where the silicon dioxide dielectric layer 13 is capable of being doped with boron-phosphorus impurities for improving fluidity and foreign impurity adsorbability of the silicon nitride thin film.

In step S14, as shown in FIG. 14, configuring the photoresist to define a pattern of a source region trench contact hole 14 and a pattern of a gate interconnection region contact hole 15 through the photoetching technology. Since the source region trench is formed previously, at this time, critical dimensions of the pattern of the source region trench contact hole and the pattern of the gate interconnection region contact hole are relatively large, which has good tolerance of the photoetching technology.

In step S15, as shown in FIG. 15, etching the silicon dioxide dielectric layer 13 through the dry etching to obtain the source region trench contact hole 14 and the gate interconnection trench contact hole 15.

In the step S16, as shown in FIG. 16, etching silicon nitride in a source region trench through hot phosphoric acid.

In the step S 17, as shown in FIG. 17, doping an impurity having high concentration to a bottom of the source region trench, forming an ohmic contact 16 of the source region trench contact hole, and activating the impurity trough rapid thermal annealing; depositing metal and nitride as a protective layer through a physical vapor deposition technology, forming silicide through rapid thermal degradation, where the metal includes one or more of titanium, cobalt, and tantalum.

In the step S 18, as shown in FIG. 18, depositing metal tungsten through a tungsten bolt technology, removing a part of the metal tungsten other than each of the contact holes through the dry etching, to obtain the tungsten bolts 17.

In the step S19, as shown in FIG. 19, respectively depositing aluminum-copper compound 18 though the physical vapor deposition technology, forming the circuit through the photoetching technology and the dry etching.

In the step S20, as shown in FIG. 20, depositing a passivation layer 19 and etching the passivation layer 19 through the photoetching technology, where the passivation layer 19 includes silicon nitride or silicon dioxide.

Finally performing an alloying technology, at this point, the manufacturing method of the trench type power device is completed.

Specific embodiments of the present disclosure are described above. It should be understood that the present disclosure is not limited to the specific embodiments described above, and a person skilled in the art may make various changes or modifications within the scope of the claims, which does not affect the essential content of the present disclosure. In the case of no conflict, the embodiments of the present disclosure and the features in the embodiments may be combined with each other.

## Claims

1. A manufacturing method of a trench type power device, comprising:
step A, preparing a cellular structure;
step B, preparing contact holes and tungsten bolts;
step C, performing etching to form a circuit; and
step D, depositing a passivation layer and etching the passivation layer.

2. The manufacturing method of the trench type power device according to claim 1, wherein the step A specifically comprises:
step S1, performing chemical vapor deposition on an upper surface of a silicon substrate with one or more epitaxial layers, where each of the one or more epitaxial layers is doped with trivalent elements and pentavalent elements;
step S2, depositing a mask on an upper surface of each of the one or more epitaxial layers, where a component of the mask is a photoresist or a multi-layer combination structure composed of a photoresist and an insulator mask;
step S3, defining a pattern of a gate trench and a pattern of a source trench on the mask, where the gate trench comprises a cellular gate trench and a gate interconnection trench, a pattern of the cellular gate trench, the pattern of the source trench, and a pattern of the gate interconnection trench are sequentially arranged, a critical dimension of the gate interconnection trench is greater than a critical dimension of the cellular gate trench, and the critical dimension of the cellular gate trench is greater than a critical dimension of the source trench;
step S4, forming a pattern of the circuit on the mask, and then forming the pattern of the circuit on each of the one or more epitaxial layers through dry etching to obtain a depth of the gate interconnection trench greater than a depth of the cellular gate trench greater than a depth of the source trench;
step S5, performing rounding and plasma damage repair on the cellular gate trench, the source trench, and the gate interconnection trench through a thermal oxidation method, growing an oxide layer on each of side walls of the cellular gate trench, the source trench, and the gate interconnection trench, and processing the oxide layer through wet etching;
step S6, growing a silicon nitride thin film through low-pressure chemical vapor deposition, where the silicon nitride thin film grows on a bottom surface of the gate trench and fills the source trench;
step S7, etching the silicon nitride thin film through hot phosphoric acid, where the silicon nitride thin film is still retained in the source trench until the silicon nitride thin film in the gate trench is completely etched;
step S8, removing a natural oxide layer in the gate trench through the wet etching, and growing a gate oxide layer through the thermal oxidation method;
step S9, forming polysilicon through low-pressure chemical vapor deposition for filling the gate trench with the polysilicon to form a gate, doping the pentavalent elements in a deposition process of the polysilicon or doping the trivalent elements through ion implantation after the gate is formed;
step S10, removing a part of the polysilicon higher than the one or more epitaxial layers through chemical mechanical polishing or the dry etching;
step S 11, doping a first impurity into the upper surface of each of the one or more epitaxial layers through the ion implantation to obtain a body region, activating the first impurity in the body region through a thermal process, where the first impurity comprises the trivalent elements or the pentavalent elements; and
step S12, doping a second impurity into an upper surface of the body region through the ion implantation to obtain a source region, where the second impurity implanted by the ion implantation is the pentavalent elements or the trivalent elements, so as to finally obtain the cellular structure.

3. The manufacturing method of the trench type power device according to claim 2, wherein in the step S1, the step S9, the step S11, and the step S12, the trivalent elements comprise boron element, and the pentavalent elements comprises arsenic element and phosphorus element.

4. The manufacturing method of the trench type power device according to claim 2, wherein a polarity of the first impurity doped through the ion implantation in the step S11 is opposite to a polarity of the trivalent elements and the pentavalent elements doped in each of the one or more epitaxial layers in the step S1, and a polarity of the second impurity doped by the ion implantation in the step 12 is same as the polarity of the trivalent elements and the pentavalent elements doped in each of the one or more epitaxial layers in the step S1.

5. The manufacturing method of the trench type power device according to claim 2, wherein a thickness of the oxide layer in the step S5 is 10-100 nm, a thickness of the oxide layer after being processed by the wet etching is 20 nm; a thickness of the silicon nitride thin film in the step S6 is 500-1000 nm, a thickness of the gate oxide layer in the step S8 is 10-100 nm, and a thickness of the polysilicon in the step S9 is 500-1000 nm.

6. The manufacturing method of the trench type power device according to claim 2, wherein the step B specifically comprises:
step S13, forming a silicon dioxide dielectric layer through chemical vapor deposition;
step S14, configuring the photoresist to define a pattern of a source region trench contact hole and a pattern of a gate interconnection region contact hole through the photoetching technology, where the pattern of the source region trench contact hole is located above the source trench, and the pattern of the gate interconnection region contact hole is located above the gate interconnection trench;
step S15, etching the silicon dioxide dielectric layer through the dry etching to obtain the source region trench contact hole and the gate interconnection trench contact hole;
step S16, etching silicon nitride in a source region trench through hot phosphoric acid;
step S17, doping a third impurity having high concentration to a bottom of the source region trench, forming an ohmic contact of the source region trench contact hole, and activating the third impurity trough rapid thermal annealing; depositing metal and nitride as a protective layer through a physical vapor deposition technology, forming silicide through rapid thermal degradation, where the metal comprises one or more of titanium, cobalt, and tantalum; and
step S 18, depositing metal tungsten through a tungsten bolt technology, removing a part of the metal tungsten other than each of the contact holes through the dry etching, and forming each of the tungsten bolts in each of the contact holes.

7. The manufacturing method of the trench type power device according to claim 6, wherein the polarity of the second impurity doped through the ion implantation in the step S12 is same as a polarity of the third impurity doped through the ion implantation in the step S17.

8. The manufacturing method of the trench type power device according to claim 1, wherein the step C specifically comprises:
step S19, respectively depositing aluminum-copper compound above the tungsten bolts though the physical vapor deposition technology, then performing the etching through a photoetching technology and dry etching to form the circuit.

9. The manufacturing method of the trench type power device according to claim 1, wherein the step D specifically comprises:
step S20, depositing the passivation layer and etching the passivation layer through a photoetching technology, where the passivation layer comprises silicon nitride or silicon dioxide.

10. A trench type power device, wherein the trench type device is obtained through the manufacturing method of the trench type power device according to claim 1.
